# FASCICULE DE BREVET EUROPEEN

(11) **EP 1 768 911 B1**
(45) Date de publication et mention de la délivrance du brevet: **18.08.2010**
(21) Numéro de dépôt: 05754510.5
(22) Date de dépôt: 22.06.2005
(51) Int. Cl.: B65D 23/02, C23C 16/511

(54) **MACHINE DE TRAITEMENT DE RÉCIPIENTS COMPORTANT DES MOYENS DE PRÉHENSION COMMANDÉ POUR SAISIR LES RÉCIPIENTS PAR LEUR COL**
BEHÄLTERBEHANDLUNGSMASCHINE MIT GESTEUERTEN GREIFMITTELN ZUM ERGREIFEN VON BEHÄLTERN AM HALS
CONTAINER-TREATMENT MACHINE COMPRISING CONTROLLED GRIPPING MEANS FOR SEIZING CONTAINERS BY THE NECK

(30) Priorité: 24.06.2004 FR 0451327
(43) Date de publication de la demande: 04.04.2007
(73) Titulaire: SIDEL PARTICIPATIONS, 76930 Octeville-sur-Mer (FR)
(72) Inventeur: MOUCHELET, Marc, SIDEL, F-76930 Octeville sur Mer (FR); DUCLOS, Yves-Alban SIDEL, F-76930 Octeville sur Mer (FR); DANEL, Laurent SIDEL, F-76930 Octeville sur Mer (FR)
(74) Mandataire: Kohn, Philippe
(86) Numéro de dépôt international: PCT/EP2005/052904
(87) Numéro de publication internationale: WO 2006/000561

(56) Documents cités:
- FR-A- 2 783 667
- US-A1- 2003 217 527

## Description

La présente invention concerne une machine de traitement de récipients pourvus d'un col, tels que des bouteilles, des flacons ou similaires.

La présente invention concerne plus particulièrement une machine de traitement de récipients du genre susmentionné par dépôt d'un revêtement interne formant barrière au moyen d'un plasma micro-ondes, notamment en vue de permettre le conditionnement de liquides oxydo-sensibles dans les récipients, comportant au moins un poste de traitement pour un récipient muni d'un col, chaque poste de traitement comprenant une tuyère qui comporte des moyens de préhension pour saisir extérieurement le récipient par son col et des moyens pour raccorder de manière étanche l'intérieur du récipient avec un circuit de pompage à vide, du type dans laquelle la tuyère est montée à coulissement suivant un axe sensiblement vertical par rapport à une enceinte de traitement, entre une position axiale de transfert et une position axiale de traitement de manière à permettre l'insertion axiale de la récipient à l'intérieur de l'enceinte par une ouverture correspondante, la tuyère comportant une portion annulaire de fermeture qui vient en appui axial étanche contre une portion correspondante de l'enceinte pour en fermer ladite ouverture, du type dans laquelle les moyens de préhension comportent un manchon tubulaire de support, coaxial au col du récipient, qui est fixe par rapport à la tuyère et qui est muni d'une série de perçages radiaux débouchants prévus pour recevoir chacun une bille mobile radialement entre une position interne de préhension dans laquelle la bille coopère avec le col pour saisir le récipient et une position externe de libération.

Dans ce type de machine, le récipient est généralement agencé à l'endroit, c'est-à-dire avec le col dirigé vers le haut, la tuyère coulissant axialement du haut vers le bas pour saisir le récipient, pendant une phase de préhension, et l'amener dans l'enceinte, et du bas vers le haut pour sortir le récipient et pour le libérer, pendant une phase de libération.

Les billes montées dans la tuyère sont sollicitées radialement contre le col du récipient par un joint torique en matériau élastique.

Avec une tuyère équipée d'un tel type de moyens de préhension, la préhension du récipient se fait par un montage à force de la manière suivante. Pendant la phase de préhension, la tuyère exerce un effort axial du haut vers le bas sur le récipient pour repousser les billes radialement vers l'extérieur, à l'encontre de la force élastique de rappel appliquée par le joint torique sur les billes, de manière à permettre l'insertion du col du récipient dans la tuyère.

Le récipient est alors saisi par son col au moyen des billes qui exercent une force radiale d'appui contre le col, sous la sollicitation du joint torique.

De manière similaire, la libération du récipient se fait par un démontage à force. Pendant la phase de libération, le récipient est retenu axialement vers le bas par un élément qui visent en appui axial contre un épaulement du récipient, de manière à repousser les billes vers l'extérieur et de manière à permettre le retrait axial de la tuyère vers le haut par rapport au récipient, à l'encontre de la force élastique de rappel appliquée par le joint torique sur les billes.

Ce type de moyens de préhension présente des inconvénients car il provoque des efforts relativement importants sur le récipient, pendant la phase de préhension et pendant la phase de libération.

De plus, lorsque le récipient est saisi par son col, les billes appliquent une force radiale d'appui sur la paroi axiale convexe du col, ce qui peut détériorer le col.

La présente invention vise notamment à remédier à ces inconvénients.

Dans ce but, l'invention propose une machine de traitement du type décrit précédemment, **caractérisée en ce que** les moyens de préhension comportent un manchon tubulaire de commande qui est coaxial et externe au manchon de support, et qui est monté coulissant axialement, par rapport au manchon de support, entre une position axiale verrouillée, dans laquelle une portée tronconique, qui est agencée sur la paroi axiale concave du manchon de commande, coopère avec les billes pour les solliciter radialement vers leur position de préhension, et une position axiale déverrouillée, dans laquelle les billes sont libres de se déplacer vers leur position de libération,
et en ce que la tuyère comporte des moyens d'entraînement commandés susceptibles de provoquer le coulissement axial du manchon de commande vers au moins une de ses deux positions axiales déterminées.

Selon d'autres caractéristiques de l'invention :
- les moyens de préhension comportent au moins un élément élastique de rappel qui sollicite le manchon de commande vers sa position verrouillée, et les moyens d'entraînement sont prévus pour provoquer le coulissement du manchon de commande depuis sa position verrouillée vers sa position déverrouillée, à l'encontre de l'élément de rappel ;
- l'élément de rappel est interposé axialement entre le manchon de commande et le manchon de support ;
- les moyens d'entraînement comportent un vérin pneumatique ou hydraulique qui est muni d'un piston lié en coulissement axial au manchon de commande, au moins dans le sens du déverrouillage ;
- le piston est constitué d'un manchon tubulaire qui est coaxial et externe au manchon de commande et qui comporte une surface radiale en appui axial contre une portée radiale associée du manchon de commande ;
- le manchon de commande est assemblé sur le manchon de support pourvu des billes de manière à former un sous-ensemble interchangeable ;
- la tuyère étant portée par un couvercle qui est monté coulissant axialement par rapport à l'enceinte et qui comporte un capot supérieur et un capot inférieur, le manchon de support comporte, à son extrémité axiale opposée au col, une collerette radiale externe qui est serrée axialement entre le capot supérieur et le capot inférieur du couvercle, de manière à retenir le sous-ensemble interchangeable sur le couvercle ;
- les moyens de raccordement étanche comportent une cartouche globalement tubulaire, coaxiale au col du récipient, qui est montée dans le couvercle, et qui est munie, à l'une de ses extrémités axiales, d'un joint annulaire d'étanchéité, et la paroi axiale concave du manchon de support comporte un épaulement qui est prévu pour venir en appui axial contre le joint annulaire d'étanchéité ;
- le col du récipient comporte une collerette radiale externe, et, lorsque les billes se déplacent radialement vers leur position de préhension, elles coopèrent avec la collerette radiale externe de manière à solliciter axialement le récipient vers le joint annulaire d'étanchéité.

D'autres caractéristiques et avantages de l'invention apparaîtront à la lecture de la description détaillée qui suit pour la compréhension de laquelle on se reportera aux dessins annexés dans lesquels :
- la figure 1 est une vue en coupe axiale partielle éclatée qui représente schématiquement un poste de traitement de la machine selon l'invention lorsque le couvercle occupe une position axiale haute de transfert par rapport au châssis ;
- la figure 2 est une vue similaire à la précédente qui représente schématiquement le couvercle dans une position axiale intermédiaire lorsque un récipient est saisi par des moyens de préhension et partiellement introduit dans une enceinte de traitement ;

- la figure 3 est une vue en coupe axiale qui représente partiellement le couvercle lorsque les moyens de préhension sont prêts à saisir le col d'un récipient ;
- la figure 4 est une vue en coupe axiale qui représente partiellement le couvercle équipé d'une cartouche et d'un injecteur d'acétylène lorsque le couvercle occupe sa position basse de traitement et qu'il vient fermer l'enceinte de traitement, un récipient étant saisi par les moyens de préhension ;
- la figure 5 est une vue en perspective qui représente partiellement le capot inférieur du couvercle en position basculée vers le bas, le sous-ensemble formant les moyens de préhension étant partiellement monté dans son logement ;
- la figure 6 est une vue en perspective qui représente partiellement le capot supérieur du couvercle avant le montage de la cartouche, l'organe de verrouillage de la cartouche occupant sa position de libération.

Dans la description qui va suivre, des éléments identiques, similaires ou analogues seront désignés par les mêmes chiffres de référence.

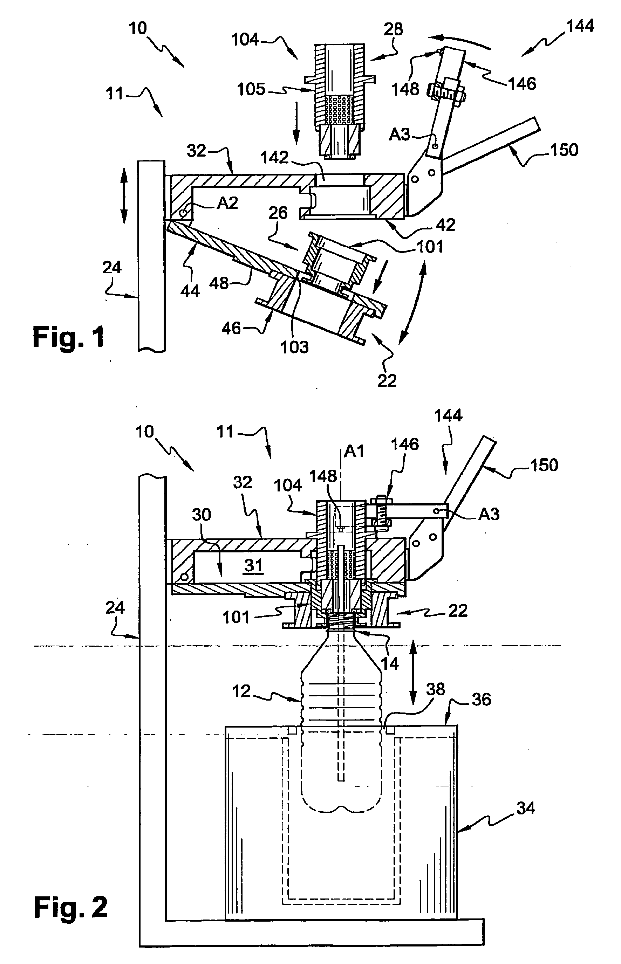

Sur la figure 1, on a représenté partiellement une machine 10 de traitement de récipients 12, ici des bouteilles, qui est réalisée conformément aux enseignements de l'invention.

La machine 10 vise à réaliser le dépôt d'un revêtement interne formant barrière au moyen d'un plasma micro-ondes, notamment en vue de permettre le conditionnement d'un liquide oxydo-sensible dans les récipients 12.

De manière- classique, la machine 10 comporte plusieurs postes 11 de traitement qui peuvent être répartis circonférentiellement de manière régulière sur un support rotatif (non représenté), chaque poste 11 de traitement étant prévu pour traiter un récipient 12 à la fois.

Sur les figures, on a représenté partiellement un seul poste 11 de traitement.

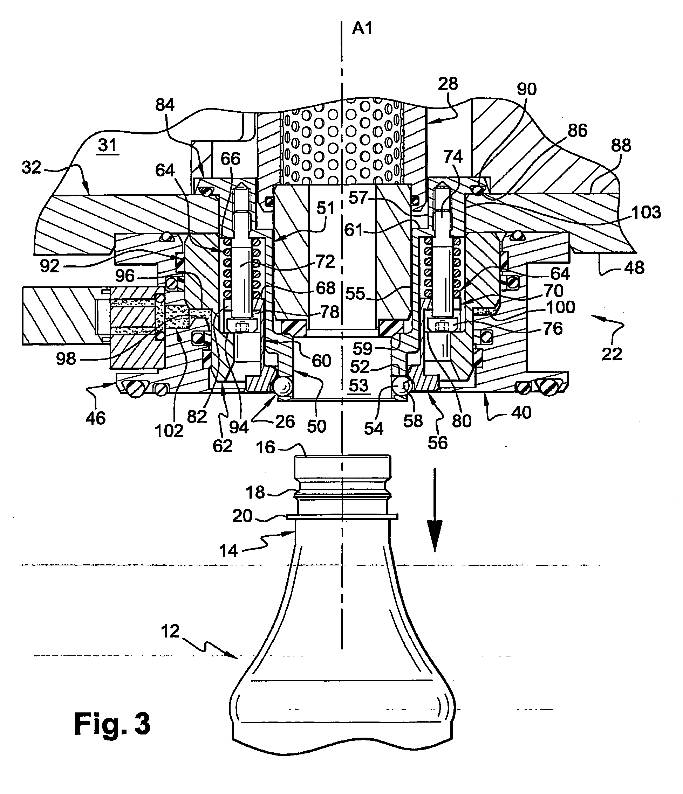

Comme on peut le voir en particulier sur la figure 3, chaque récipient 12 est muni, à son extrémité axiale supérieure, d'un col 14 qui délimite une ouverture supérieure dont le rebord constitue le buvant 16 du récipient 12.

Le col 14 est muni d'une première collerette radiale externe 18 et d'une seconde collerette radiale externe 20 agencée sous la première collerette radiale externe 18.

De façon avantageuse, lorsque le récipient 12 est une bouteille, la première collerette radiale externe 18 peut être constituée par la bague d'inviolabilité qui est en général présente sur le col de la bouteille et est destinée à coopérer avec un anneau d'inviolabilité présent sur le bouchon, et qui se déchire lorsque le récipient est ouvert.

Chaque poste 11 de traitement comporte une tuyère 22 de forme globalement cylindrique qui est montée à coulissement suivant un axe A1, dit axe de coulissement et sensiblement vertical par rapport à un châssis 24, fixe, de la machine 10.

Dans la suite de la description, on utilisera à titre non limitatif une orientation axiale verticale suivant l'axe A1 de coulissement, ce qui correspond à une orientation du haut vers le bas sur les figures.

Des éléments seront qualifiés de radiaux ou de transversaux en fonction de leur disposition par rapport à l'axe A1 de coulissement.

La tuyère 22 comporte des moyens de préhension 26 pour saisir extérieurement le récipient 12 par son col 14 et des moyens de raccordement 28 pour raccorder de manière étanche l'intérieur du récipient 12 avec un circuit 30 de pompage à vide.

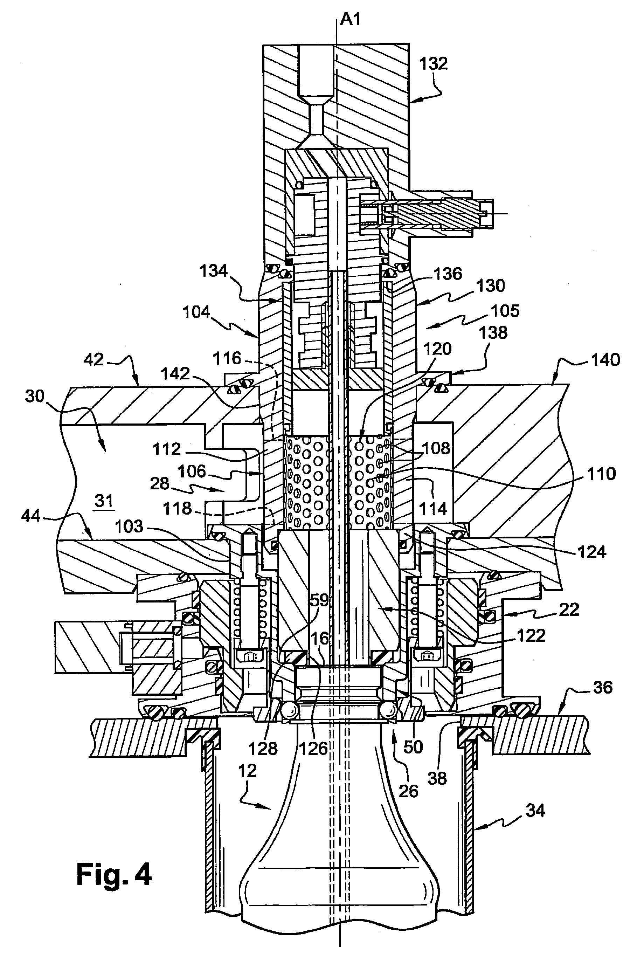

Selon le mode de réalisation représenté ici, la tuyère 22 est portée par un couvercle 32, et le couvercle 32 est monté coulissant axialement sur le châssis 24, entre une position haute de transfert, qui est représentée sur les figures 1 et 3, et une position basse de traitement, qui est représentée sur la figure 4.

Sur les figures, on a représenté une portion du circuit 30 de pompage qui est constituée par une chambre 31 de pompage aménagée à l'intérieur du couvercle 32 et qui est prévue pour être raccordée au récipient 12 par les moyens de raccordement 28.

Chaque poste 11 de traitement comporte aussi une enceinte 34 de traitement qui est fixée sur le châssis 24.

L'enceinte 34 de traitement comporte, dans une portion 36, ici constituée par sa face transversale supérieure, une ouverture 38 qui est prévue pour permettre l'insertion axiale du récipient 12 à l'intérieur de l'enceinte 34 de traitement.

La tuyère 22 comporte une portion annulaire de fermeture 40 qui est prévue pour venir en appui axial étanche contre ladite portion 36 correspondante, constituée ici par la face transversale supérieure de l'enceinte 34 de traitement, de manière à fermer ladite ouverture 38.

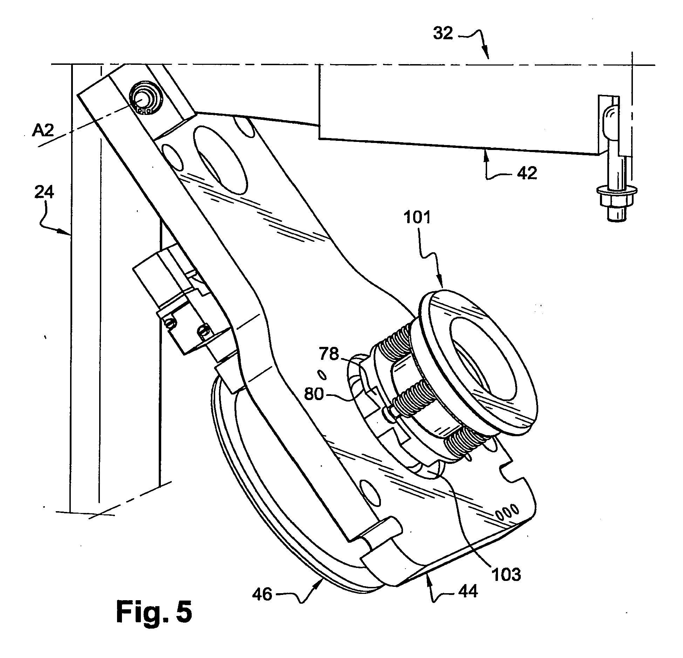

Le couvercle 32 comporte ici un capot supérieur 42 qui est monté à coulissement sur le châssis 24 et un capot inférieur 44 qui est monté à pivotement autour d'un axe transversal A2 par rapport au capot supérieur 42, entre une position ouverte de démontage, qui est représentée sur les figures 1 et 5, et une position fermée d'utilisation, qui est représentée notamment sur la figure 2.

L'utilité de la position de démontage sera expliquée par la suite.

La tuyère 22 comporte un corps principal 46 annulaire globalement cylindrique qui est fixé par son extrémité axiale supérieure sur la face transversale inférieure 48 du couvercle 32.

La face transversale d'extrémité inférieure du corps principal 46 constitue ici la portion annulaire de fermeture 40 de la tuyère 22.

Les moyens de préhension 26 comportent un manchon de support 50 qui est tubulaire et coaxial au col 14 du récipient 12, qui est fixe par rapport au corps principal 46 de la tuyère 22, et qui est muni d'une série de perçages radiaux 52 débouchants prévus pour recevoir chacun une bille 54 mobile radialement entre une position interne de préhension, qui est représentée sur la figure 4, et une position externe de libération, qui est représentée sur la figure 3.

Les perçages radiaux 52 sont ici de forme globalement cylindrique et ils constituent chacun un logement pour une bille 54.

De préférence, les perçages radiaux 52 sont agencés au voisinage de l'extrémité axiale inférieure du manchon de support 50 et ils sont répartis angulairement de manière régulière.

Lorsque les billes 54 occupent leur position radiale interne de préhension, elles sont prévues pour coopérer avec le col 14 du récipient 12 de manière à saisir le récipient 12.

Lorsque les billes 54 occupent leur position radiale externe de libération, elles sont prévues pour permettre le retrait du récipient 12 par rapport à la tuyère 22.

Selon le mode de réalisation représenté ici, la paroi axiale concave 51 du manchon de support 50 est étagée axialement de sorte qu'elle comporte un tronçon cylindrique d'extrémité axiale inférieure 53, un tronçon cylindrique intermédiaire 55, et un tronçon cylindrique d'extrémité axiale supérieure 57 qui sont adjacents et qui sont des diamètres internes respectifs croissants vers le haut.

Le tronçon cylindrique d'extrémité axiale inférieure 53 délimite avec le tronçon cylindrique intermédiaire 55 un épaulement 59 orienté vers le haut.

-- - Le tronçon cylindrique intermédiaire 55 délimite avec le tronçon cylindrique d'extrémité axiale supérieure 57 une surface radiale 61 orientée vers le haut.

Avantageusement, la dimension axiale du tronçon cylindrique d'extrémité axiale inférieure 53 est sensiblement égale à la dimension axiale du col 14 du récipient 12 depuis la seconde collerette radiale externe 20 jusqu'au buvant 16 de manière que, lorsque le récipient 12 est saisi par les moyens de préhension 26, le buvant 16 soit agencé sensiblement à la même hauteur que l'épaulement 59, et que les billes 54 coopèrent par contact avec la première collerette radiale externe 18 en vue de solliciter le récipient 12 axialement vers le haut.

Conformément aux enseignements de l'invention, les moyens de préhension 26 comportent un manchon de commande 56 qui est tubulaire, coaxial et externe au manchon de support 50.

Ce manchon de commande 56 est monté coulissant axialement par rapport au manchon de support 50 entre une position axiale inférieure verrouillée, qui est représentée sur la figure 4, et une position axiale supérieure déverrouillée, qui est représentée sur la figure 3.

Le manchon de commande 56 comporte une portée tronconique 58 qui est agencée sur sa paroi axiale concave 60 et qui est prévue pour coopérer avec les billes 54 de manière à les solliciter radialement vers leur position de préhension, lorsque le manchon de commande 56 coulisse depuis sa position déverrouillée vers sa position verrouillée.

A l'inverse, lorsque le manchon de commande 56 occupe sa position déverrouillée, les billes 54 sont libres de se déplacer radialement entre leur position de préhension et leur position de libération.

Selon une autre caractéristique de l'invention, la tuyère 22 comporte des moyens d'entraînement 62 commandés susceptibles de provoquer le coulissement axial du manchon de commande 56 vers au moins une de ses deux positions axiales déterminées, c'est-à-dire la position axiale verrouillée et la position axiale déverrouillée.

Avantageusement, les moyens de préhension 26 comportent au moins un élément élastique de rappel 64 qui sollicite axialement le manchon de commande 56 vers sa position verrouillée.

Les moyens d'entraînement 62 sont prévus pour provoquer le coulissement du manchon de commande 56 depuis sa position verrouillée vers sa position déverrouillée, à l'encontre de l'élément élastique de rappel 64.

Selon le mode de réalisation représenté ici, les moyens de préhension 26 comportent plusieurs éléments élastiques de rappel 64 constitués par des ressorts 64 à boudins de compression.

Les ressorts 64 sont répartis angulairement de manière régulière et ils sont interposés axialement entre une surface radiale annulaire 66 du manchon de support 50, qui est orientée vers le bas, et une surface radiale annulaire 68 en vis-à-vis constituée par la face supérieure d'une collerette radiale externe 70 appartenant au manchon de commande 56.

La collerette radiale externe 70 est agencée ici à l'extrémité axiale supérieure du manchon de commande 56.

Chaque ressort 64 est enroulé autour d'une vis 72 axiale qui traverse la collerette radiale externe 70 du manchon de commande 56 et qui est vissée par son extrémité supérieure filetée 74 dans la surface radiale annulaire 66 du manchon de support 50.

Chaque vis 72 comporte, à son extrémité inférieure, une tête 76 qui est logée axialement dans une encoche 78 associée formée dans la surface radiale inférieure de la collerette radiale externe 70 du manchon de commande 56.

On note que la profondeur axiale de l'encoche 78 est supérieure à la hauteur axiale de la tête 76.

Chaque encoche 78 est ouverte radialement vers l'extérieur, comme on peut le voir notamment sur la figure 5.

De plus, la collerette radiale externe 70 du manchon de commande 56 comporte, dans chaque encoche 78, une fente 82 qui est ouverte radialement vers l'extérieur et qui permet le passage de la vis 72 associée à travers la collerette radiale externe 70.

Avantageusement, le manchon de support 50 comporte, à son extrémité axiale supérieure, une collerette radiale externe 84 qui s'étend radialement au-delà du diamètre externe du manchon de commande 56.

La collerette radiale externe 84 du manchon de support 50 comporte une surface radiale annulaire inférieure 86 qui est prévue pour venir en appui axial contre une surface transversale supérieure 88 du capot inférieur 44, de manière que la collerette radiale externe 84 puisse être serrée axialement entre le capot supérieur 42 et le capot inférieur 44 du couvercle 32, en vue de retenir axialement le manchon de support 50 sur le couvercle 32.

La surface radiale annulaire inférieure 86 comporte ici un logement pour un joint torique 90 visant à assurer l'étanchéité du contact entre la collerette radiale externe 84 et la surface transversale supérieure 88 associée du capot inférieur 44.

Avantageusement, les moyens d'entraînement 62 du manchon de commande 56 comportent un vérin pneumatique ou hydraulique qui est muni d'un piston 92 lié en coulissement axial au manchon de commande 56, au moins dans le sens du déverrouillage.

Le piston 92 est constitué ici par un manchon tubulaire qui est coaxial et externe au manchon de commande 56.

Le piston 92 comporte, dans sa paroi axiale concave, une surface radiale 94, interne, qui est orientée vers le haut et qui est prévue pour venir en appui axial contre une portée radiale 80 associée du manchon de commande 56 pour permettre l'entraînement du manchon de commande 56 par le piston 92 lorsque le piston 92 se déplace axialement vers le haut.

La portée radiale 80 est ici constituée par la surface radiale inférieure de la collerette radiale externe 70 du manchon de commande 56.

Le piston 92 comporte, dans sa paroi axiale convexe, un épaulement radial externe 96 qui est orienté vers le bas et qui délimite axialement, avec une portée radiale 98 en vis-à-vis aménagée dans le corps principal 46 de la tuyère 22, une chambre de commande 100 du piston 92.

Le corps principal 46 de la tuyère 22 comporte ici un conduit d'alimentation 102 en air comprimé qui est raccordé à une source de pression (non représentée). Ainsi, l'augmentation de la pression à l'intérieur de la chambre de commande 100 provoque le coulissement du piston 92 vers le haut, ce qui entraîne le coulissement du manchon de commande 56 vers sa position déverrouillée.

On note que la course axiale du piston 92, et donc du manchon de commande 56, peut être très courte, par exemple de l'ordre de 2,5 mm.

Avantageusement, le manchon de support 50, les billes 54, le manchon de commande 56, les ressorts 64, les vis 72, et le joint torique 90 sont préalablement assemblés de manière à constituer un sous-ensemble interchangeable 101, qui peut ainsi être monté en une seule opération dans le capot inférieur 44 du couvercle 32.

A cet effet, le capot inférieur 44 comporte un logement 103 cylindrique qui débouche coaxialement à l'intérieur du corps principal 46 de la tuyère 22.

Le sous-ensemble interchangeable 101 est inséré axialement du haut vers le bas dans le logement 103 du capot inférieur 44, jusqu'à ce que la collerette radiale externe 84 du manchon de support 50 vienne en appui axial contre la surface transversale supérieure 88 du capot inférieur 44.

Le sous-ensemble interchangeable 101 est monté serré axialement entre une surface d'appui appartenant au capot supérieur 42 et la surface transversale supérieure 88 du capot inférieur 44.

On décrit maintenant les moyens de raccordement 28 qui équipent la tuyère 22 selon l'invention.

Les moyens de raccordement 28 sont constitués par un sous-ensemble amovible appelé cartouche 104 qui a une forme globalement tubulaire coaxiale au col du récipient 12.

La cartouche 104 comporte un tronçon axial, dit tronçon de raccordement 106, qui s'étend à l'intérieur de la chambre 31 de pompage et qui est pourvu d'orifices radiaux 108.

La chambre 31 de pompage communique avec l'intérieur de la cartouche 104 uniquement à travers les orifices radiaux 108, les dimensions nominales de chaque orifice 108 étant aptes à empêcher la diffusion vers la chambre 31 de pompage des micro-ondes émises à l'intérieur du récipient 12 pendant le traitement.

La cartouche 104 comporte un corps principal 105, tubulaire, dont le tronçon d'extrémité axiale inférieure constitue ici le tronçon de raccordement 106.

Selon le mode de réalisation représenté ici, le tronçon de raccordement 106 comporte deux fenêtres 110 diamétralement opposées qui sont découpées dans sa paroi axiale.

Chaque fenêtre 110 est délimitée, circonférentiellement, par deux montants axiaux 112, 114 et, axialement, par deux rebords radiaux 116, 118.

Chaque fenêtre 110 est obturée par un élément de paroi axiale rapporté 120 dans lequel sont agencés les orifices radiaux 108.

L'élément de paroi axiale rapporté 120 est constitué ici par un manchon perforé 120 qui est coaxial au tronçon de raccordement 106, qui est réalisé d'une seule pièce, et qui est inséré axialement à l'intérieur de la cartouche 104 de manière à obturer les deux fenêtres 110.

Le manchon perforé 120 comporte une multitude d'orifices radiaux 108 identiques qui s'étendent sur toute sa surface axiale.

Le manchon perforé 120 est réalisé par exemple en métal.

On note que la dimension nominale de la section de passage de chaque orifice radial 108 et l'épaisseur radiale du manchon perforé 120 sont choisies de manière à empêcher la diffusion vers le circuit 30 de pompage, et tout particulièrement vers la chambre 31 de pompage, des micro-ondes émises à l'intérieur du récipient 12 pendant le traitement, tout en minimisant les pertes de charge lors du pompage à vide.

La cartouche 104 comporte une entretoise 122 tubulaire qui est emmanchée à force axialement dans l'extrémité axiale inférieure 124 du tronçon de raccordement 106.

L'entretoise 122 est intercalée axialement entre le buvant 16 du récipient 12 et le corps principal 105 de la cartouche 104.

L'extrémité axiale inférieure 126 de l'entretoise 122 est pourvue d'un joint annulaire 128 d'étanchéité qui est prévu pour réaliser un raccordement étanche entre la cartouche 104 et l'intérieur du récipient 12.

Avantageusement, lorsque la cartouche 104 est montée dans le couvercle 32, le joint annulaire 128 vient en appui axial étanche à la fois contre l'épaulement 59 interne du manchon de support 50 et contre le buvant 16 du récipient 12.

Selon le mode de réalisation représenté ici, le corps principal 105 de la cartouche 104 comporte un tronçon d'extrémité axiale supérieure, dit tronçon de liaison 130, qui prolonge le tronçon de raccordement 106 vers le haut.

Le tronçon de liaison 130 possède une paroi axiale pleine et il est en contact étanche, par son extrémité axiale libre supérieure, avec le corps d'un injecteur 132 prévu pour injecter de l'acétylène à l'intérieur du récipient 12 pendant le traitement.

La cartouche 104 comporte une chemise cylindrique 134 qui est agencée contre la paroi axiale concave du tronçon de liaison 130 et qui s'étend globalement sur toute la longueur axiale du tronçon de liaison 130.

Selon le mode de réalisation représenté ici, la chemise cylindrique 134 est montée en butée axiale contre une surface radiale associée 136 qui est orientée vers le bas et qui est agencée au voisinage de l'extrémité axiale supérieure du tronçon de liaison 130.

Le manchon perforé 120 est retenu axialement à l'intérieur de la cartouche 104, en haut par l'extrémité axiale inférieure de la chemise cylindrique 134, et en bas par l'extrémité axiale supérieure de l'entretoise 122.

Le tronçon de liaison 130 est pourvu d'une collerette radiale externe 138 qui vient en appui axial étanche contre la surface transversale supérieure 140 du couvercle 32, lorsque la cartouche 104 est montée dans le couvercle 32.

La cartouche 104 est prévue ici pour être insérée axialement, du haut vers le bas, dans un logement 142 cylindrique complémentaire du couvercle 32.

Le logement 142 cylindrique est constitué par un trou qui est aménagé dans le capot supérieur 42, axialement en vis-à-vis du logement 103 prévu pour recevoir le manchon de support 50 des moyens de préhension 26.

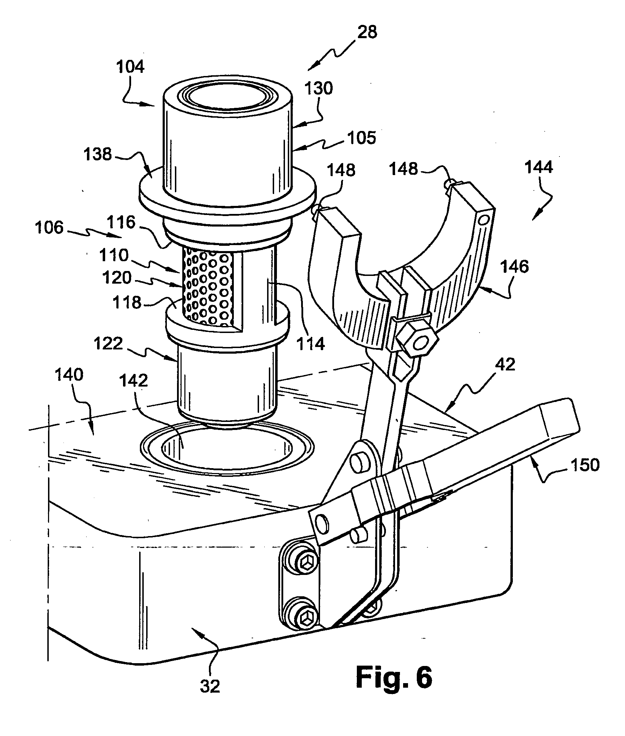

Le couvercle 32 est équipé d'un organe de verrouillage 144 qui comporte une fourche 146 montée pivotante autour d'un axe transversal A3 entre une position angulaire verrouillée, qui est représentée sur la figure 2, et une position angulaire de libération, qui est représentée sur les figures 1 et 6.

La fourche 146 a globalement une forme en U qui s'étend dans un plan transversal en position verrouillée et qui délimite une encoche globalement complémentaire de la forme extérieure du tronçon de liaison 130 de la cartouche 104.

La face transversale inférieure de la fourche 146, en position verrouillée, est munie de deux plots 148 qui s'étendent verticalement vers le bas et qui forment à leurs extrémités axiales inférieures respectivement deux surfaces transversales prévues pour venir en appui axial contre la face radiale supérieure de la collerette radiale externe 138 du tronçon de liaison 130.

Les plots 148 sont agencés ici au voisinage des extrémités libres de la fourche 146.

De préférence, chaque plot 148 est constitué par une vis qui est vissée dans la face transversale inférieure de la fourche 146 et qui comporte une tête formant surface d'appui.

Ainsi, il est possible de régler précisément la hauteur des surfaces d'appui de la fourche 146 sur la collerette radiale externe 138 en vissant plus ou moins chaque vis constituant un plot 148.

L'organe de verrouillage 144 est équipé d'un levier 150 qui commande le pivotement de la fourche 146 entre ses deux positions angulaires.

Le fonctionnement des moyens de préhension 26 et des moyens de raccordement 28 équipant la machine 10 de traitement selon l'invention est le suivant.

Comme expliqué précédemment, le sous-ensemble interchangeable 101 est constitué en assemblant le manchon de commande 56 sur le manchon de support 50, avec les billes 54, les ressorts 64 et les vis 72.

De manière similaire, les éléments constituant la cartouche 104, c'est-à-dire son corps principal 105, la chemise cylindrique 134, le manchon perforé 120, l'entretoise 122, ainsi que les joints d'étanchéité qui l'équipent, sont assemblés au préalable.

Le capot inférieur 44 du couvercle 32 est ouvert, en le faisant pivoter vers le bas autour de son axe A2, de manière à permettre l'insertion axiale du sous-ensemble interchangeable 101 du haut vers le bas dans le logement 103 associé, comme on l'a représenté sur les figures 1 et 5.

Cette opération est effectuée alors que le couvercle 32 occupe sa position haute de transfert.

Le capot inférieur 44 peut alors être refermé en le faisant pivoter vers le haut contre le capot supérieur 42, de sorte que le sous-ensemble interchangeable 101 est alors serré axialement entre le capot inférieur 44 et le capot supérieur 42, comme on l'a représenté sur les figures 2, 3, et 4.

L'organe de verrouillage 144 occupant sa position de libération, la cartouche 104 est insérée axialement, du haut vers le bas, dans le logement 142 associé, jusqu'à ce que la collerette radiale externe 138 du tronçon de liaison 130 vienne en appui axial contre la surface transversale supérieure 140 du couvercle 32 du capot supérieur 42.

Une action sur le levier 150 de commande provoque ensuite le pivotement de la fourche 146 vers sa position verrouillée, telle que représentée sur la figure 2, ce qui bloque axialement la cartouche 104 dans sa position montée.

On note que, dans la position montée de la cartouche 104, le joint annulaire 128, qui équipe l'extrémité axiale inférieure 126 de l'entretoise 122, vient en appui axial étanche contre l'épaulement 59 interne du manchon de support 50 du sous-ensemble interchangeable 101.

Le corps de l'injecteur 132 peut alors être déplacé axialement vers le bas de manière à venir en appui axial étanche contre l'extrémité axiale supérieure du tronçon de liaison 130 de la cartouche 104, comme on l'a représenté sur la figure 4.

On note que, pour simplifier la représentation, les éléments de l'injecteur 132 n'ont pas été représentés sur les autres figures.

A ce stade, les moyens de préhension 26 et les moyens de raccordement 28 étant montés sur le couvercle 32, ils sont prêts à fonctionner.

La phase de préhension d'un récipient 12 se déroule de la manière suivante.

Le récipient 12 à saisir est placé axialement sous la tuyère 22, par exemple par l'intermédiaire d'une roue d'alimentation (non représentée), comme représenté sur la figure-3.

Le manchon de commande 56 est commandé depuis sa position de préhension jusqu'à sa position de libération, telle que représentée sur la figure 3, par l'intermédiaire du piston 92 pour permettre l'insertion du col 14 du récipient 12 dans le manchon de support 50.

Des moyens de commande (non représentés) provoquent le coulissement axial du couvercle 32 vers le bas, jusqu'à ce le col 14 du récipient 12 soit reçu axialement à l'intérieur du tronçon cylindrique d'extrémité axiale inférieure 53 du manchon de support 50.

En relâchant la pression dans la chambre de commande 100 du piston 92, le manchon de commande 56 est entraîné vers sa position verrouillée sous l'action des ressorts 64, ce qui sollicite radialement les billes 54 vers leur position de préhension, contre la paroi axiale du col 14 du récipient 12, comme on l'a représenté sur la figure 4.

L'appui radial des billes 54 contre la première collerette radiale externe 18 sollicite légèrement le récipient 12 vers le haut, de sorte que le buvant 16 vient bien en appui axial étanche contre le joint annulaire 128 équipant l'entretoise 122.

A ce stade, le récipient 12 est saisi par les moyens de préhension 26, ce qui permet au couvercle 32 de poursuivre son coulissement axial vers le bas, de manière à introduire axialement le récipient 12 à l'intérieur de l'enceinte 34 pour permettre son traitement.

Le couvercle 32 descend jusqu'à sa position axiale de traitement, qui est représentée sur la figure 4, dans laquelle la tuyère 22 vient fermer de manière étanche l'enceinte 34 de traitement.

Dans la position axiale de traitement, le pompage à vide de l'intérieur du récipient 12 peut commencer, ainsi que le traitement du récipient 12.

Après le traitement du récipient 12, le couvercle 32 est commandé en coulissement vers sa position haute de transfert, et le manchon de commande 56 est commandé dans sa position de libération, pour permettre l'évacuation du récipient 12 traité hors de la machine.

Les moyens de préhension 26 et le couvercle 32 peuvent alors être commandés de manière à saisir un nouveau récipient 12 à traiter, de la même manière que décrite précédemment.

Pendant le traitement du récipient 12, les micro-ondes émises à l'intérieur de l'enceinte 34 de traitement provoquent des dépôts de carbone sur les faces axiales internes de la cartouche 104.

Grâce au tronçon de raccordement 106 et au manchon perforé 120, le champ des micro-ondes est cantonné à l'intérieur de la cartouche 104 ce qui empêche le dépôt de carbone dans la chambre de pompage 31.

Après le traitement d'un nombre déterminé de récipients 12, la cartouche 104 peut être démontée de manière à permettre le nettoyage des surfaces qui ont subi des dépôts de carbone répétés.

Dans la machine 10 selon l'invention, le démontage de la cartouche 104 est facilité puisqu'il suffit de faire coulisser axialement le corps de l'injecteur 132 vers le haut, celui-ci nécessitant aussi un nettoyage, puis de faire pivoter la fourche 146 vers sa position de libération. La cartouche 104 peut alors être retirée manuellement, sans outil, et être remplacée tout aussi facilement.

Avantageusement, une cartouche 104 de remplacement peut être prévue de manière à permettre le nettoyage de la cartouche 104 usagée en temps masqué pendant le fonctionnement de la machine 10.

On note que le dépôt de carbone à l'intérieur de la cartouche 104 diminue exponentiellement vers le haut. Par conséquent, le dépôt de carbone se concentre principalement sur la surface axiale concave de l'entretoise 122.

Le nettoyage de la cartouche 104 peut donc se résumer au nettoyage de l'entretoise 122 et de son joint annulaire 128.

Les moyens de préhension 26 selon l'invention présentent l'avantage d'être agencés en dehors du champ des micro-ondes, de sortent qu'ils ne subissent pas de dépôt de carbone.

Comme les moyens d'entraînement 62 du manchon de commande 56 sont montés sur le corps principal 46 de la tuyère 22 qui est lui-même fixé sur le capot inférieur 44 du couvercle 32, le sous-ensemble interchangeable 101 peut être démonté sans qu'il soit nécessaire de démonter les moyens d'entraînement 62.

Ceci permet de prévoir des sous-ensembles interchangeables 101 en fonction de la forme du col 14 du récipient 12, sans qu'il soit nécessaire de modifier les moyens d'entraînement 62 et/ou le corps principal 46 de la tuyère 22.

De plus, l'opération de changement du sous-ensemble interchangeable 101 est particulièrement simple puisqu'il suffit de faire basculer le capot inférieur 44 du couvercle 32 vers le bas.

Les moyens de préhension 26 selon l'invention facilitent la personnalisation du poste 11 de traitement en fonction de la forme des récipients 12 à traiter.

On note que la tuyère 22 est pourvue de plusieurs joints d'étanchéité, qui n'ont pas tous été référencés, pour assurer le pompage à vide dans le récipient 12 et la fermeture étanche de l'enceinte 34 de traitement.

De préférence, un capteur de proximité (non représenté) qui est agencé sur le couvercle 32 détecte les moments où il faut commander le manchon de commande 56 en position de préhension ou de libération. Ce capteur de proximité peut être lié électriquement à une électrovanne qui commande la pression dans la chambre de commande 100, ce qui permet de commander les moyens de préhension 26 directement par le capteur de proximité, sans qu'il soit nécessaire de passer par l'unité de commande du poste 11 de traitement ou de la machine 10.

Grâce aux moyens de préhension 26 selon l'invention, il n'est pas nécessaire d'appliquer un effort de maintien pour maintenir le manchon de commande 56 en position verrouillée puisque cette position correspond à une position stable de repos grâce à l'action des ressorts 64.

De plus, dans la machine 10 selon l'invention, il n'est pas nécessaire d'exercer un effort sur le récipient 12 pour le libérer ou pour le saisir.

## Revendications

1. Machine (10) de traitement de récipients (12) par dépôt d'un revêtement interne formant barrière au moyen d'un plasma micro-ondes, notamment en vue de permettre le conditionnement de liquides oxydo-sensibles dans les récipients (12), comportant au moins un poste (11) de traitement pour un récipient (12) muni d'un col (14), chaque poste (11) de traitement comprenant une tuyère (22) qui comporte des moyens de préhension (26) pour saisir extérieurement le récipient (12) par son col (14) et des moyens de raccordement (28) pour raccorder de manière étanche l'intérieur du récipient (12) avec un circuit de pompage à vide (30), du type dans laquelle la tuyère (22) est montée à coulissement suivant un axe (A1) sensiblement vertical par rapport à une enceinte (34) de traitement, entre une position axiale de transfert et une position axiale de traitement de manière à permettre l'insertion axiale du récipient (12) à l'intérieur de l'enceinte (34) de traitement par une ouverture (38) correspondante, la tuyère (22) comportant une portion annulaire de fermeture (40) qui vient en appui axial étanche contre une portion (36) correspondante de l'enceinte (34) de traitement pour en fermer ladite ouverture (38), du type dans laquelle les moyens de préhension (26) comportent un manchon tubulaire de support (50), coaxial au col (14) du récipient (12), qui est fixe par rapport à la tuyère (22) et qui est muni d'une série de perçages radiaux (52) débouchants prévus pour recevoir chacun une bille (54) mobile radialement entre une position interne de préhension dans laquelle la bille (54) coopère avec le col (14) pour saisir le récipient (12) et une position externe de libération,
**caractérisée en ce que** les moyens de préhension (26) comportent un manchon de commande (56), tubulaire, qui est coaxial et externe au manchon de support (50), et qui est monté coulissant axialement, par rapport au manchon de support (50), entre une position axiale verrouillée, dans laquelle une portée tronconique (58) qui est agencée sur la paroi axiale concave du manchon de commande (56) coopère avec les billes (54) pour les solliciter radialement vers leur position de préhension, et une position axiale déverrouillée, dans laquelle les billes (54) sont libres de se déplacer vers leur position de libération,
et **en ce que** la tuyère (22) comporte des moyens d'entraînement (62) commandés susceptibles de provoquer le coulissement axial du manchon de commande (56) vers au moins une de ses deux positions axiales déterminées.

2. Machine (10) selon la revendication précédente, **caractérisée en ce que** les moyens de préhension (26) comportent au moins un élément élastique de rappel (64) qui sollicite le manchon de commande (56) vers sa position verrouillée, et **en ce que** les moyens d'entraînement (62) sont prévus pour provoquer le coulissement du manchon de commande (56) depuis sa position verrouillée vers sa position déverrouillée, à l'encontre de l'élément élastique de rappel (64).

3. Machine (10) selon l'une quelconque des revendications précédentes, **caractérisée en ce que** l'élément de rappel (64) est interposé axialement entre le manchon de commande (56) et le manchon de support (50).

4. Machine (10) selon l'une quelconque des revendications précédentes, **caractérisée en ce que** les moyens d'entraînement (62) comportent un vérin pneumatique ou hydraulique qui est muni d'un piston (92) lié en coulissement axial au manchon de commande (56), au moins dans le sens du déverrouillage.

5. Machine (10) selon la revendication précédente, **caractérisée en ce que** le piston (92) est constitué d'un manchon tubulaire qui est coaxial et externe au manchon de commande (56) et qui comporte une surface radiale (94) en appui axial contre une portée radiale (80) associée du manchon de commande (56).

6. Machine (10) selon l'une quelconque des revendications précédentes, **caractérisée en ce que** le manchon de commande (56) est assemblé sur le manchon de support (50) pourvu des billes (54) de manière à former un sous-ensemble interchangeable (101).

7. Machine (10) selon la revendication précédente, du type dans laquelle la tuyère (22) est portée par un couvercle (32) qui est monté coulissant axialement par rapport à l'enceinte (34) de traitement et qui comporte un capot supérieur (42) et un capot inférieur (44), **caractérisée en ce que** le manchon de support (50) comporte, à son extrémité axiale opposée au col (14), une collerette radiale externe (84) qui est serrée axialement entre le capot supérieur (42) et le capot inférieur (44) du couvercle (32), de manière à retenir le sous-ensemble interchangeable (101) sur le couvercle.

8. Machine (10) selon l'une quelconque des revendications précédentes, **caractérisée en ce que** les moyens de raccordement (28) étanches comportent une cartouche (104) globalement tubulaire, coaxiale au col (14) du récipient (12), qui est montée dans le couvercle (32), et qui est munie, à l'une de ses extrémités axiales, d'un joint annulaire (128) d'étanchéité, et **en ce que** la paroi axiale concave du manchon de support (50) comporte un épaulement (59) qui est prévu pour venir en appui axial contre le joint annulaire (128) d'étanchéité.

9. Machine (10) selon la revendication précédente, **caractérisée en ce que** le col (14) du récipient (12) comporte une collerette radiale externe (18), et **en ce que**, lorsque les billes (54) se déplacent radialement vers leur position de préhension, elles coopèrent avec la collerette radiale externe (18) de manière à solliciter axialement le récipient (12) vers le joint annulaire (128) d'étanchéité.

10. Machine (10) selon la revendication précédente, **caractérisée en ce que** la collerette radiale externe (18) est constituée par une bague d'inviolabilité du récipient.

## Claims

1. A machine (10) for the treatment of containers (12) by the depositing of a barrier-forming internal coating by means of a microwave plasma, especially for the purpose of allowing the packaging of oxidation-sensitive liquids in the containers (12), said machine comprising at least one treatment station (11) for a container (12) provided with a neck (14), each treatment station (11) comprising a nipple (22) which comprises gripping means (26) for seizing the container (12) externally by its neck (14) and connection means (28) for connecting the interior of the container (12) to a vacuum-pumping circuit (30) in a leaktight manner, said machine being of the type in which the nipple (22) is mounted slideably along a substantially vertical axis (A1) with respect to a treatment enclosure (34) between an axial transfer position and an axial treatment position, so as to allow the axial insertion of the container (12) into the treatment enclosure (34) via a corresponding aperture (38), the nipple (22) comprising an annular closing portion (40) which comes to bear axially against a corresponding portion (36) of the treatment enclosure (34) in a leaktight manner in order to close said aperture (38) of the latter, said machine being of the type in which the gripping means (26) comprise a tubular supporting cuff (50) which is coaxial with respect to the neck (14) of the container (12) and is fixed in relation to the nipple (22) and which is provided with a series of open-ended radial drillholes (52), each intended for receiving a ball (54) movable radially between an inner gripping position, in which the ball (54) cooperates with the neck (14) in order to seize the container (12), and an outer release position,
**characterized in that** the gripping means (26) comprise a tubular control cuff (56) which is coaxial and external with respect to the supporting cuff (50) and which is mounted axially slideably with respect to the supporting cuff (50) between a locked axial position, in which a frustoconical bearing surface (58) arranged on the concave axial wall of the control cuff (56) cooperates with the balls (54) in order to stress them radially toward their gripping position, and an unlocked axial position, in which the balls (54) are free to be displaced toward their release position,
and **in that** the nipple (22) comprises controlled drive means (62) capable of causing the axial sliding of the control cuff (56) toward at least one of its two specific axial positions.

2. The machine (10) as claimed in the preceding claim, **characterized in that** the gripping means (26) comprise at least one elastic return element (64) which stresses the control cuff (56) toward its locked position, and **in that** the drive means (62) are intended to cause the sliding of the control cuff (56) from its locked position toward its unlocked position counter to the elastic return element (64).

3. The machine (10) as claimed in either one of the preceding claims, **characterized in that** the return element (64) is interposed axially between the control cuff (56) and the supporting cuff (50).

4. The machine (10) as claimed in any one of the preceding claims, **characterized in that** the drive means (62) comprise a pneumatic or hydraulic jack which is provided with a piston (92) connected axially slideably to the control cuff (56), at least in the unlocking direction.

5. The machine (10) as claimed in the preceding claim, **characterized in that** the piston (92) consists of a tubular cuff which is coaxial and external with respect to the control cuff (56) and which comprises a radial surface (94) bearing axially against an associated radial bearing surface (80) of the control cuff (56).

6. The machine (10) as claimed in any one of the preceding claims, **characterized in that** the control cuff (56) is assembled on the supporting cuff (50) provided with the balls (54), so as to form an interchangeable subassembly (101).

7. The machine (10) as claimed in the preceding claim, of the type in which the nipple (22) is carried by a cover (32) which is mounted axially slideably with respect to the treatment enclosure (34) and which comprises an upper cap (42) and a lower cap (44), **characterized in that** the supporting cuff (50) comprises, at its axial end opposite the neck (14), an outer radial collar (84) which is clamped axially between the upper cap (42) and the lower cap (44) of the cover (32), so as to retain the interchangeable subassembly (101) on the cover.

8. The machine (10) as claimed in any one of the preceding claims, **characterized in that** the leaktight connection means (28) comprise a substantially tubular cartridge (104) which is coaxial with respect to the neck (14) of the container (12) and is mounted in the cover (32) and which is provided, at one of its axial ends, with an annular seal (128), and **in that** the concave axial wall of the supporting cuff (50) comprises a shoulder (59) which is intended to come to bear axially against the annular seal (128).

9. The machine (10) as claimed in the preceding claim, **characterized in that** the neck (14) of the container (12) comprises an outer radial collar (18), and **in that**, when the balls (54) are displaced radially toward their gripping position, they cooperate with the outer radial collar (18), so as to stress the container (12) axially toward the annular seal (128).

10. The machine (10) as claimed in the preceding claim, **characterized in that** the outer radial collar (18) consists of a tamper-proof ring of the container.

## Patentansprüche

1. Maschine (10) zur Behandlung von Behältern (12) durch Aufbringen eines inneren Sperrüberzugs mittels eines Mikrowellen-Plasmas, insbesondere um die Verpackung von sauerstoffempfindlichen Flüssigkeiten in den Behältern (12) zu ermöglichen, mit mindestens einer Behandlungsstation (11) für einen Behälter (12), der mit einem Hals (14) versehen ist, wobei jede Behandlungsstation (11) eine Düse (22) besitzt, welche Greifmittel (26) aufweist, um den Behälter (12) außen an seinem Hals (14) zu ergreifen, und Verbindungseinrichtungen (28), um das Innere des Behälters (12) dicht mit einem Vakuum-Pumpkreislauf (30) zu verbinden, wobei die Düse (22) entlang einer im wesentlichen vertikalen Achse (A1) gegenüber einer Behandlungskammer (34) verschiebbar montiert ist, und zwar zwischen einer axialen Transportposition und einer axialen Behandlungsposition, um den axialen Einschub des Behälters (12) über eine entsprechende Öffnung (38) in das Innere der Behandlungskammer (34) zu ermöglichen, wobei die Düse (22) einen ringförmigen Verschluss-Abschnitt (40) besitzt, der sich gegen einen entsprechenden Abschnitt (36) an der Behandlungskammer (34) axial und luftdicht abstützt, um die Öffnung (38) zu verschließen, wobei die Greifmittel (26) einen rohrförmigen Auflage-Stutzen (50) besitzen, der koaxial zu dem Hals (14) des Behälters (12) verläuft, und der gegenüber der Düse (22) feststehend ist, und mit einer Reihe radialer Durchgangsbohrungen (52) versehen ist, um jeweils eine radial bewegliche Kugel (54) aufzunehmen, und zwar zwischen einer inneren Greifposition, in der die Kugel (54) mit dem Hals (14) zusammenwirkt, um den Behälter (12) zu ergreifen, und einer externen Position der Freigabe,
**dadurch gekennzeichnet, dass** die Greifmittel (26) einen rohrförmigen Steuer-Stutzen (56) besitzen, der koaxial und außerhalb des Auflage-Stutzens (50) verläuft, und gegenüber dem Auflage-Stutzen (50) axial verschiebbar montiert ist, und zwar zwischen einer axialen, verriegelten Position in der eine kegelstumpfförmige Auflagefläche (58), die an der axialen, konkaven Wand des Steuer-Stutzens (56) angeordnet ist, mit den Kugeln (54) zusammenwirkt, um sie radial in ihre Greifposition zu bringen und einer axialen, entriegelten Position, in der die Kugeln (54) sich frei in ihre Position der Freigabe verschieben können,
und dass die Düse (22) gesteuerte Antriebsmittel (62) besitzt, die die axiale Verschiebung des Steuer-Stutzens (56) in mindestens eine seiner beiden festgelegten, axialen Positionen hervorrufen können.

2. Maschine (10) nach dem vorhergehenden Anspruch, **dadurch gekennzeichnet, dass** die Greifmittel (26) mindestens ein elastisches Rückholelement (64) besitzen, mit dem der Steuer-Stutzen (56) in seine verriegelte Position gedrückt wird, und dass mit den Antriebsmitteln (62) die Verschiebung des Steuer-Stutzens (56) aus seiner verriegelten Position in seine entriegelte Position gegen das elastische Rückholelement (64) erreicht wird.

3. Maschine (10) nach einem der vorhergehenden Ansprüche, **dadurch gekennzeichnet, dass** das Rückholelement (64) zwischen dem Steuer-Stutzen (56) und dem Auflage-Stutzen (50) axial eingeschoben ist.

4. Maschine (10) nach einem der vorhergehenden Ansprüche, **dadurch gekennzeichnet, dass** die Antriebsmittel (62) einen Pneumatikzylinder oder einen Hydraulikzylinder aufweisen, der mit einem Kolben (92) versehen ist, welcher in axialer Verschiebung mindestens in der Richtung der Entriegelung mit dem Steuer-Stutzen (56) verbunden ist.

5. Maschine (10) nach dem vorhergehenden Anspruch, **dadurch gekennzeichnet, dass** der Kolben (92) aus einem rohrförmigen Stutzen besteht, der sich koaxial außen an dem Steuer-Stutzen (56) befindet, und der eine radiale Oberfläche (94) besitzt, die axial gegen eine radiale Auflagefläche (80) drückt, welche mit dem Steuer-Stutzen (56) verbunden ist.

6. Maschine (10) nach einem der vorhergehenden Ansprüche, **dadurch gekennzeichnet, dass** der Steuer-Stutzen (56) mit dem Auflage-Stutzen (50), verbunden ist, welcher mit Kugeln (54) versehen ist, so dass sie eine austauschbare Untereinheit (101) bilden.

7. Maschine (10) nach dem vorhergehenden Anspruch, bei der die Düse (22) von einem Deckel (32) aufgenommen wird, der axial zu der Behandlungskammer (34) verschiebbar montiert ist, und der eine obere Klappe (42) und eine untere Klappe (44) besitzt, **dadurch gekennzeichnet, dass** der Auflage-Stutzen (50) an seinem axialen Ende gegenüber dem Hals (14) einen radialen, äußeren Bund (84) aufweist, der axial zwischen der oberen Klappe (42) und der unteren Klappe (44) des Deckels (32) eingeklemmt ist, um die austauschbare Untereinheit (101) auf dem Deckel zu halten.

8. Maschine (10) nach einem der vorhergehenden Ansprüche, **dadurch gekennzeichnet, dass** die dichten Verbindungseinrichtungen (28) eine im wesentlichen rohrförmige Hülse (104) aufweisen, die koaxial zu dem Hals (14) des Behälters (12) verläuft, und in dem Deckel (32) montiert ist, und die an einem ihrer axialen Enden einen ringförmigen Dichtungswulst (128) besitzt, und dass die axiale, konkave Wand des Auflage-Stutzens (50) einen Absatz (59) aufweist, der axial gegen den ringförmigen Dichtungswulst (128) drücken soll.

9. Maschine (10) nach dem vorhergehenden Anspruch, **dadurch gekennzeichnet, dass** der Hals (14) des Behälters (12) einen radialen, äußeren Bund (18) besitzt, und dass die Kugeln (54) wenn sie sich radial in ihre Greifposition verschieben mit dem radialen, äußeren Bund (18) zusammenwirken, so dass sie den Behälter (12) axial gegen den ringförmigen Dichtungswulst (128) drücken.

10. Maschine (10) nach dem vorhergehenden Anspruch, **dadurch gekennzeichnet, dass** der radiale, äußere Bund (18) aus einem Sicherheitsverschluss (Sicherheitsring) besteht, welcher die Unversehrtheit des Verschlusses bestätigt.
